# EUROPEAN PATENT SPECIFICATION

(11) **EP 0 348 119 B1**
(45) Date of publication and mention of the grant of the patent: **13.08.1997**
(21) Application number: 89306148.1
(22) Date of filing: 16.06.1989
(51) Int. Cl.: H01L 21/768, H01L 21/288

(54) **Method of processing metal connectors on semi-conductor devices**
Verfahren zur Herstellung von metallischen Verbindungen auf Halbleiterbauelemente
Procédé pour la fabrication de connexions métalliques sur des dispositifs à semiconducteur

(30) Priority: 23.06.1988 JP 153512/88; 30.09.1988 JP 246454/88
(43) Date of publication of application: 27.12.1989
(73) Proprietor: KABUSHIKI KAISHA TOSHIBA, Kawasaki-shi, Kanagawa-ken 210 (JP)
(72) Inventor: Hayasaka, Nobuo Intellectual Property Division, 1-1-1, Shibaura Minato-ku Tokyo (JP); Maeda, Ayako Intellectual Property Division, 1-1-1, Shibaura Minato-ku Tokyo (JP); Okano, Haruo Intellectual Property Division, 1-1-1, Shibaura Minato-ku Tokyo (JP)
(74) Representative: Freed, Arthur Woolf

(56) References cited:
- EP-A- 0 085 332
- EP-A- 0 211 318
- EP-A- 0 236 034
- DE-B- 1 224 841
- US-A- 3 400 012
- US-A- 3 632 436
- Intergrated Circuits, by W.C. Till et al. Prentice-Hall, Inc. NJ, USA,1982.
- Deposition Technologies for films and coatings, R.F. Bunshah et al., Noyes Publications, USA, 1982.
- SOLID STATE TECHNOLOGY vol. 16, no. 12, December 1973, pages 87-92, Princeton, NJ, US; N Feldstein: "Electroless plating in the semiconductor industry"
- Patent Abstracts of Japan vol. 12, no. 263 (C-514)(3110), 22 July 1988; & JP-A-63047374
- Patent Abstracts of Japan vol. 8, no. 29 (E226)(1466), 7 February 1984; & JP-A-58190025
- EXTENDED ABSTRACTS vol..87, no.1, 1987, page 343, Princeton, New Jersey, US; C.H. TING et al.: "Selective metal deposition by chemical reduction process for multilevel interconnection"

## Description

This invention relates to a method of manufacturing semiconductor devices, and more particularly to a method of processing the surfaces of metal leads of the device so as to suppress corrosion thereof. The invention also relates to a method of selectively depositing metal on prescribed portions of the device.

In a conventional method of manufacturing semiconductor devices, the metal leads of most devices are formed using materials such as Al, an Al-Si alloy or an Al-Si-Cu alloy. The metal leads of such devices are generally formed as follows. Specifically, a thin metal film is formed on a semiconductor substrate by the use of a vacuum evaporation technique, a sputtering technique or the like. Next, a photoresist is painted on the thin metal film so as to form a photoresist film. The photoresist film is then patterned in a prescribed manner. Thereafter, the thin metal film is selectively etched using the thus patterned photoresist film as a mask. This is performed by the use of a dry-etching technique such as an RIE (reactive ion etching) technique or the like. As a result, the thin metal film is formed into metal leads having a prescribed pattern. In general, gas of the Cl group is used for etching metals such as Al or an Al-alloy. However, after such a dry-etching process using the Cl group gas, Cl remains on the surface of the thin film of Al or an Al-alloy. The remaining Cl corrodes the Al film or an Al-alloy film, which is exposed to air without any protection. If one of metal leads is corroded in a semiconductor device, such a metal lead can be broken when the device is operated. This is because the current density in the metal lead becomes abnormally higher. As a result, reliability of the device is significantly lowered.

To prevent the above-described corrosion, the following techniques have been generally employed after the dry-etching process, such as the RIE. Specifically, a technique has been employed in which an electrical discharge is performed using gas of the F group. This causes the surfaces of the metal leads to be fluorinated. Another technique has been employed in which the metal leads are washed with water immediately after the RIE. Another technique has been employed in which heated inert gas is supplied to the metal leads after the RIE. Still another technique has been employed in which a semiconductor substrate to be processed is heated by a heater. The surfaces of metal leads are processed by one of the above-described techniques. Thereafter, the photoresist, which has been used as a mask, is eliminated. Next, the substrate to be processed is further washed with water. In this process, F or Cl still adheres to the surfaces of metal leads. As a result, corrosion of the metal leads inevitably occurs.

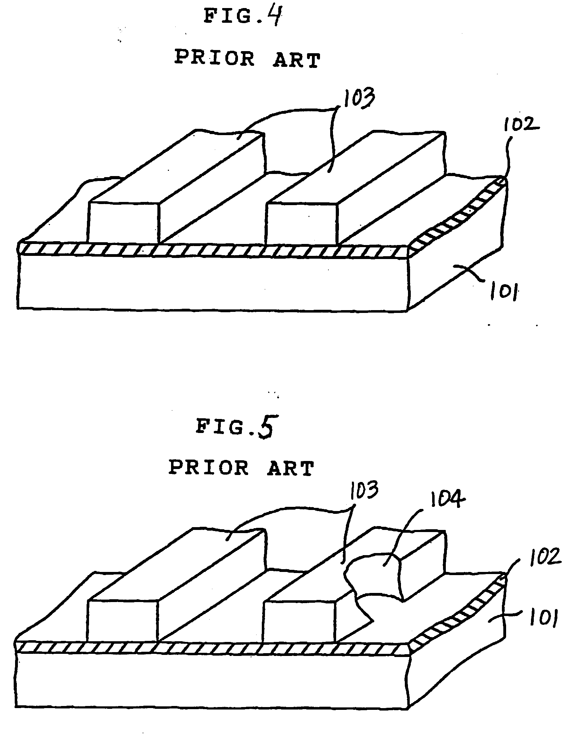

Figure 4 is a schematic perspective view illustrating a part of a conventional semiconductor device. In Figure 4, a silicon oxide film 102 is formed on the surface of a silicon substrate 101. Next, a metal lead film made of an Al-Si-Cu alloy is formed on the silicon oxide film 102. Thereafter, the metal lead film is selectively etched using a photoresist (not shown) as a mask so as to form metal leads 103. Figure 4 shows a state in which the photoresist has been eliminated. The substrate 101 of Figure 4 is washed with high-purity water. In this process, a corroded portion 104 appears at a portion of the metal leads 103 as shown in Figure 5. This corrosion is caused by F and Cl adhered to the surfaces of metal leads 103. Assume that a semiconductor device is finished leaving the corroded portion 104. When such a device is actually operated, the electric current density in the thinned portion 104 becomes higher. As a result, the portion 104 of metal leads 103 can be easily broken, causing disconnection of the circuit. This significantly lowers the reliability of the semiconductor device.

In the process of eliminating the photoresist, an ashing technique using O₂ gas excitation has been employed. However, in recent years, an ashing technique using gas of the F group has been employed in some cases. In such cases, the metal leads are exposed to gas of the F group, thus F remains on the surfaces of the metal leads. As a result, corrosion occurs more frequently than the case when O₂ gas is used.

Further, such corrosion occurs most significantly in the metal leads of an Al-Si-Cu alloy as compared to those of an Al-Si alloy and to those of Al (least). The reason to use such an alloy is that the electromigration in the metal leads can be significantly suppressed when they are made of an alloy, in particular, of an Al-Si-Cu alloy. Namely, the highest reliability of metal leads can be obtained when an Al-Si-Cu alloy is used. However, metal leads of an alloy have other disadvantages as follows. Specifically, oxidation and reduction can occur in a water solution because of the electrode potential difference between two different metals (i.e., cell effect). For example, in the case of an Al-Si-Cu alloy, corrosion accompanied with the growth of Al(OH)₃ occurs when the surfaces of metal leads are exposed to the water solution. This corrosion occurs even when F or Cl does not exist on the metal lead surfaces.

In the process of forming metal leads, a technique in which metal is selectively deposited on metal portions or semiconductors has many advantages. However, only limited numbers of such techniques are available at present. For example, in one technique, W is selectively deposited on W or Si by using WF₆ gas. This technique has advantage as follows. Specifically, the difference in reactive characteristics between a base material and W or Si on which W is deposited can be effectively utilized. However, this technique also has disadvantages as follows. Specifically, this requires a vacuum apparatus. Further, it is difficult to safely handle WF₆ gas. Moreover, this technique is only applicable to W, i.e., no other materials can be used. In another technique, metal is selectivley deposited on prescribed portions of a substrate by using laser beams or electron beams. Specifically, metal is deposited only on prescribed portions to which laser beams or electron beams are applied. This technique is applicable to various metals other than W. The experimental results using this technique can be easily obtained.

For example, literature on this technique, such as D.J Erhlick et al, J.Vac.Sci. & Tech. vol.21, No.1, P.23, 1982, is known. However, this technique requires a large scale system in which laser beams or electron beams are applied to a substrate situated in an atmosphere of gas (or in a solution) containing metal. Therefore, this technique is at present very far from the stage of practical application in view of its higher manufacturing costs and lower productivity.

In the article "Electroless Plating in the Semiconductor Industry" by N. Feldstein, published in Solid State Technology, vol. 16, Nr. 12, 1973, pages 87-92, the deposition of several metals on different substrates is described.

As described above, in the conventional process of manufacturing semiconductor devices, corrosion of metal leads inevitably occurs, causing reliability of the device to be lowered. Moreover, it is extremely difficult to selectively deposit various metals other than W on the metal and semiconductor portions of the device.

Accordingly, one object of this invention is to provide a method of manufacturing semiconductor devices, in particular, a method of processing the surfaces of metal leads, so as to suppress corrosion thereof.

Thus, the present invention provides a method according to claim 1 of manufacturing semiconductor devices comprising the steps of:
forming aluminium or aluminium alloy leads on the surface of a semiconductor substrate, including a step of dry etching; and
immersing the semiconductor substrate in a solution containing aluminium, for depositing aluminium on the exposed surfaces of the leads and for eliminating at least one of F and Cl adhering to the leads due to said dry etching, thereby suppressing corrosion of the leads.

A more complete appreciation of the invention and many of the attendant advantages thereof will be readily obtained as the same becomes better understood by reference to the following detailed description when considered in connection with the accompanying drawings, wherein:
FIGURES 1a and 1b are perspective cross-sectional views for explaining a preferred embodiment according to the present invention;
FIGURE 2 is a graph illustrating temperature characteristics of a substrate processed in accordance with an example not forming part of present invention;
FIGURE 3 is a graph for explaining the advantages of a comparative example; and
FIGURES 4 and 5 are perspective cross-sectional views for explaining a conventional technique.

In accordance with an example not forming part of this invention, a semiconductor substrate on which metal films have been formed is immersed in a solution containing metal. The metal in the solution is separated therefrom and deposited on the metal films. In another case, the metal on the metal films on the substrate is substituted by the metal separated from the solution. As a result, corrosion of the metal film surface can be prevented. In another case, an Al-Si-Cu alloy film on which halogen elements such as F or Cl are adhered is immersed in a solution containing metal having an ionization tendency equal to or smaller than that of Al. As a result, corrosion of the alloy film can be prevented.

An alloy of the Al-Si-Cu group has a reliability higher than that of Al or an Al-Si alloy in terms of anti-electromigration. Thus, an Al-Si-Cu alloy is best used as a material of metal leads in a semiconductor device. However, when the metal leads of an Al-Si-Cu alloy is immersed in a water solution, oxidation and reduction can occur in the solution. This is because an Al-Si-Cu alloy has an electro-chemical electrode potential difference between two differeent metals (cell effect). Thus, even when an Al-Si-Cu alloy is immersed in a water solution having substantially no impurities (so-called high-purity water), corrosion accompanied with the growth of Al(OH₃) occurs.

Further, if F or Cl is adhered to the surface of an Al-Si-Cu alloy, corrosion accompanied with the formation of HF or HCl occurs significantly when the alloy is immersed in high-purity water. Here, if an Al-Si-Cu alloy is immersed in a solution containing Fe which is metal having an ionization tendency smaller than that of Al, Fe is separated from the solution and deposited on the surface of an Al-Si-Cu alloy. Further, if F or Cl is adhered to the surface of such an alloy, and when the alloy is immersed in the solution containing Fe, F or Cl becomes HF or HCl and dissolves in the solution. At the same time, Fe is separated from the solution, and deposited on the surface of the alloy. Thus, corrosion of the alloy surface does not occur.

As described above, when the metal contained in a solution is appropriately selected with respect to the metal of Al-Si-Cu alloy films, satisfactory results can be obtained as follows. Specifically, the metal can be separated from the solution, and deposited on the surface of an Al-Si-Cu alloy. Further, F or Cl, which is adhered to the surface of this alloy, can be eliminated. In the case of Al or an Al-Si alloy, this metal has less cell effect, and is inherently corrosion-resistant. However, if F or Cl is adhered to the surface of such metal, and when the metal is immersed in a solution, corrosion also occurs. When Al or an Al-Si alloy with F or Cl adhered is immersed in a solution containing Fe, the Fe is also separated from the solution, and deposited on the surface of the metal. In this case, the amount of Fe deposited on the surface of the Al or an Al-Si alloy is smaller than that in the case of an Al-Si-Cu alloy. At the same time, F or Cl adhered to the surface of the Al or an Al-Si alloy is eliminated, and corrosion thereof can be prevented. As described above, if once metal, which has been appropriately selected, is deposited on the surface of an Al-Si-Cu alloy film, the alloy film can be prevented from corrosion even when it is immersed in high-purity water.

In recent years, an attempt has been made in which Cu is used instead of an Al-alloy as a material of metal leads in a semiconductor device. However, also in the case of Cu leads, if F or Cl is adhered to the surfaces of Cu leads, corrosion can easily occur when the device is immersed in a solution. In this case, such corrosion can also be prevented by immersing Cu leads in a solution containing metal.

Here, a solution containing metal includes water, an acid water solution or an alkaloid water solution, in each of which salt of metal is dissolved. The salt of metal includes nitrate, sulfate and organic acid salt. However, haloid salt is not suitable for such a solution. This is because if the concentration of halogen negative ion in the solution is high, corrosion can no longer be prevented. Further, oxides and hydrate other than the above-described salt of metal may also be used for such a solution.

In most cases, the metal contained in a solution exists as ion. Here, the metal in the solution must have an ionization tendency smaller than that of metal or a semiconductor on the surface of a substrate to be processed. This is required in order that the metal can be separated from the solution and deposited on the substrate surface in a prescribed manner. This is obvious from the phenomena of electro-chemical oxidation and reduction. Conventionally, metals to be deposited on an Al-alloy are metals having an ionization tendency smaller than that of the Al-alloy. Such metals are Zn, Fe, Ni, Sn, Pb, Cu, Ag, Pt, Au, W, Mo, Ti, Ho, Cr, Mn and Cd. In most cases, nitrate, organic acid salt or sulfate, each combining one of the above-described metals is dissolved in a water solution. Thereafter, the substrate on which Al-alloy films have been formed is immersed in the thus prepared water solution. As a result, one of the above-described metals is separated from the solution and deposited on the Al-alloy films in a prescribed manner.

As described above, in processing the surfaces of metal leads on the substrate, the metal in the solution is separated therefrom and deposited on the surfaces of the metal leads. Further, when a substance other than metal, such an SiO₂ film, coexists on the substrate surface, a small amount of the metal in the solution is deposited also on the SiO₂ film. Assume that metal leads of an Al-Si-Cu alloy are formed on an SiO₂ film provided on a silicon substrate. Further, this substrate is immersed in a solution containing Fe. In this case, Fe in the solution is deposited on the Al-Si-Cu alloy, and at the same time, a small amount (about 1/10 or less) of Fe is deposited also on the SiO₂ film. The Fe of a specified amount or more on the SiO₂ film becomes a contaminant that has some adverse effect on the device configuration. Thus, the unnecessary Fe deposited on the SiO₂ film must be eliminated. When the substrate, is washed with high-purity water alone, the amount of such Fe is reduced to about 1/2. In some cases, further reduction of the Fe is required for more accurate circuit configuration. In such cases, the substrate is immersed in a dilute acid solution, which dissolves the Fe.

Specifically, a large amount of metal is deposited on the metal and semiconductor portions, while a small amount of metal is deposited on the insulators, such as SiO₂ and photoresist films on the substrate. Further, when appropriate metal is deposited on the surfaces of metal leads made of an Al-Si-Cu alloy, electromigration in the metal leads can be suppressed. Particularly when one of metals such as Ni, Sn or Ho is deposited on the surface of the metal leads of Al-Si-Cu alloy, the metal leads exhibit significant anti-electromigration characteristics. In this case, if the substrate is thermally processed, such electromigration can be more effectively suppressed. This is because the metal deposited on the surfaces of metal leads is thermally diffused into the metal which originally exists in the metal leads.

In accordance with an example not forming part of this invention, a semiconductor substrate on which metal films have been formed is immersed in a solution. The solution contains negative ion precluding halogen, i.e., NO₃⁻, SO₄²⁻ or COOH⁻. As a result, a passivity layer is formed on the surface of the metal film. A passivity is a state in which metal exhibits precious metal properties. In other words, it is a state in which metal is completely covered with a thin transparent film of hydrated oxide.

In this example, corrosion of the metal leads of an Al-Si-Cu alloy on the substrate can be prevented as follows. As described above, an Al-Si-Cu alloy has high reliability in anti-electromigration, but is liable to corrosion. A substrate on which metal leads of an Al-Si-Cu alloy have been formed is immersed in a solution containing NO₃ ion. As a result, a passivity film is formed on the surfaces of the metal leads. Thus, corrosion of the metal leads can be prevented. Further, even when F or Cl is adhered to the surfaces of the metal leads, such F or Cl is completely dissolved in the solution. In this case the concentration of the NO₃ ion in the solution must be 1 ppm. at a minimum. When the concentration of the NO₃ ion is insufficient, corrosion of the metal leads can easily occur.

Such a solution may also contain metal ion accompanied with the NO₃ ion. Further, when the metal ion has an ionization tendency smaller than that of the metal on the substrate, corrosion of the metal leads can be significantly prevented. For example, Fe is a metal having an ionization tendency smaller than that of Al. Thus, when the substrate to be processed is immersed in a solution containing Fe accompanied with NO₃ ion, satisfactory results can be obtained.

Further, even when F or Cl is adhered to the surfaces of the metal leads, such F or Cl becomes HF or HCl and is dissolved in the solution. At the same time, Fe in the solution is deposited on the surfaces of the metal leads. Thus, the metal leads can be protected from corrosion.

Here, the solution containing NO₃ ion is a water solution in which nitrate of metal is dissolved. The water solution may also contain other negative ions besides NO₃ ion. However, halogen ion of a high concentration (about 10 ppm. or more) must be avoided in this solution. Otherwise, the metal leads can be corroded.

In still another example not forming part of this invention, a semiconductor substrate, which partially exposes metal and semiconductor portions, is processed as follows. First, the substrate is immersed in a solution containing metal. The metal in the solution is chemically reduced at the surfaces of the metal and semiconductor portions, and deposited thereon. In another case, the metal in the solution is substituted by the metal atoms or semiconductor atoms of the respective surfaces, and deposited thereon. In this case, the amount of metal deposited on the insulators on the substrate is far smaller (less than 1/10) than that deposited on the metal and semiconductor portions. Therefore, even when metal and semiconductor portions coexist with insulators on the substrate, the metal in the solution can be selectively deposited on the metal and semiconductor portions on the substrate.

In the process of manufacturing semiconductor devices, the following metals are generally used for metal leads and electrodes on the substrate. Specifically, the metals are Al, an Al-alloy, refractory metals (such as W and Mo), and silicides of these metals, or Cu and an Cu alloy. These metals are used for various applications as follows. For example, one of these metals is used as a barrier which improves contact characteristics (to lower contact resistance and to enhance adhesion) between the base metal and the metal leads. Another metal is used for coating the metal leads so as to suppress their electromigration and stressmigration. Another metal is used for controlling the light reflection factor in the process of photoetching. In this embodiment, all these metals can be selectively deposited on the respective metal and semiconductor portions.

When a substrate on which insulators have been formed is immersed in a solution containing metal, the metal in the solution is deposited also on the insulators. The amount of the metal deposited on the insulators is far smaller than that deposited on the metal and semiconductor portions on the substrate. This occurs, for example, when Fe is deposited on an Al-alloy film, at the same time Fe is deposited also on SiO₂ films. The amount of Fe deposited on the SiO₂ film is far smaller than that deposited on the Al-alloy film. The Fe deposited on the SiO₂ films can have some adverse effect on the circuit configuration in the later processes. The unnecessary metal deposited on the SiO₂ film can be eliminated as follows. For example, when the surface of the SiO₂ film is washed with high-purity water alone, the metal deposited on the SiO₂ film can be reduced to about half.

Thereafter, the substrate is immersed in a dilute acid solution, which dissolves the unnecessary metal. As a result, the metal deposited on the SiO₂ can be completely eliminated, leaving the necessary metal on the metal and semiconductor on the substrate. This selective elimination of the metals can be achieved because of a large difference between the amounts of the necessary and unnecessary metals. Other techniques of eliminating unnecessary metal can be obtained as follows. Specifically, they are a technique of applying charged particles such as electron or ion, a technique of applying a light beam, and a technique of thermal processing. Further, a technique of applying plasma or light in an atmosphere of reactive gas can also be obtained.

In this example, a method of selectively depositing metal on the metal and semiconductor portions on a substrate is provided. However, this embodiment can also be applied to a method of depositing metal on the entire surface of the metal and semiconductor portions on a substrate. In this case, metal in a solution is deposited on the entire surface of the metal and semiconductor portions on the substrate. Thereafter, the thus metal-deposited surface is patterned by etching or the like. Further, in this example, after the deposition of a first metal, a second metal can be deposited selectively or in an isotropic manner by the use of another technique. For example, Ti is deposited on an Al-alloy. Thereafter, W is selectively deposited on the thus Ti-deposited Al-alloy by using a reducing reaction of WF₆ gas. Further, various materials can be used for fabricating a multi-layer configuration by performing depositions several times.

Moreover, in this example, metal deposited on a layer is caused to be alloyed with the base layer of a substrate. Further, a portion of the metal deposited on the layer is caused to be diffused into the base layer. As a result, a satisfactory adhesion property of the deposited metal layer with respect to the base layer can be achieved. These processes are performed by heating the substrate at prescribed temperatures. Specifically, the substrate is heated at temperatures below 500°C to enhance the adhesion property of the deposited layer. The substrate is heated at temperatures higher than 400°C ro achieve the alloying and diffusion into an Al-alloy.

Hereinafter, referring now to the drawings, wherein like reference numerals designate identical or corresponding parts throughout the several views.

FIGURE 1a shows a substrate to be processed in accordance with an example not forming part of the present invention. In FIGURE 1a, an SiO₂ film 12 is formed on the surface of a silicon substrate 11. Two parallel-arranged metal leads 13 of an Al-Si-Cu alloy are formed on the SiO₂ film 12. The metal leads 13 are formed as follows. Specifically, an Al-Si-Cu alloy film is formed on the entire surface of the SiO₂ film 12. Thereafter, photoresist is painted on the entire surface of the alloy film. The thus painted photoresist is etched by a conventional photoetching process to form prescribed patterns. Next, the Al-Si-Cu alloy film is selectively etched using a patterned photoresist as a mask. This is performed by use of an RIE (reactive ion etching) using a gas of the Cl group. Thereafter, the photoresist is reduced to ashes by an ashing apparatus using the F group gas. As a result, the photoresist is removed.

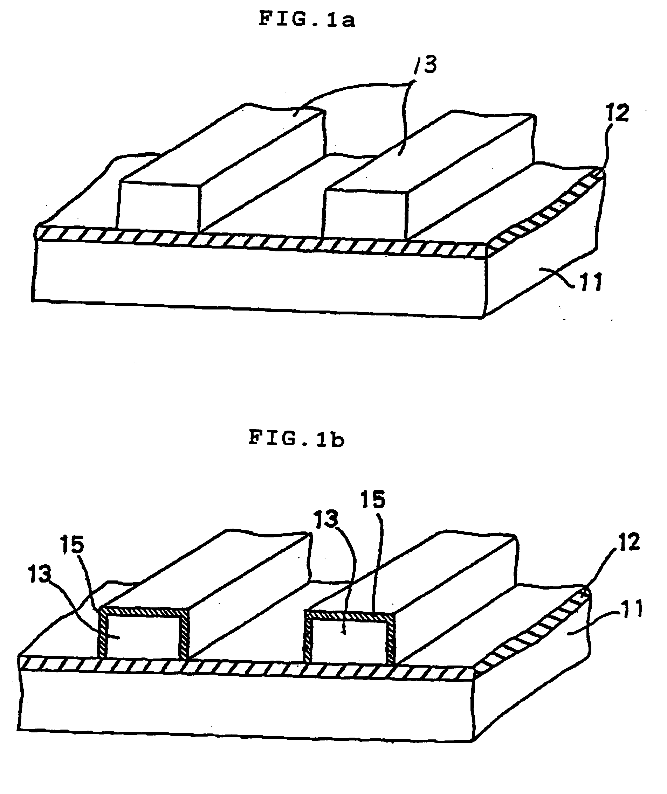

Thereafter, the substrate 11 of FIGURE 1a is washed with a water solution in which Fe is dissolved as nitrate. (Fe : 5 ppm; NO₃ : 30 ppm). The Fe in the water solution is separated therefrom, and is deposited on the surfaces of the metal leads 13. As a result, thin Fe films 15 are formed on the surfaces of the metal leads 13, as shown in FIGURE 1b. The thin Fe films 15 are not corroded even when they are washed with high-purity water. Thus, even when the substrate 11 is immersed in the high-purity water so as to be washed, the metal leads 13 are not corroded.

In this case, a large amount of Fe is deposited on the metal leads 13 of Al-Si-Cu alloy while a far smaller amount of Fe is deposited on the SiO₂ film 12. The Fe deposited on the SiO2 film 12 can be reduced to about half only by washing the substrate 11 with high-purity water. Further, when the substrate 11 is immersed in a very dilute acid solution (e.g., HF), Fe deposited on the SiO₂ film 12 can be eliminated completely. At the same time, the Fe deposited on the metal leads 13 of Al-Si-Cu alloy is also reduced. However, the amount of Fe deposited on the metal leads 13 is sufficiently larger than that of the SiO₂ film 12. Thus, this causes no problems.

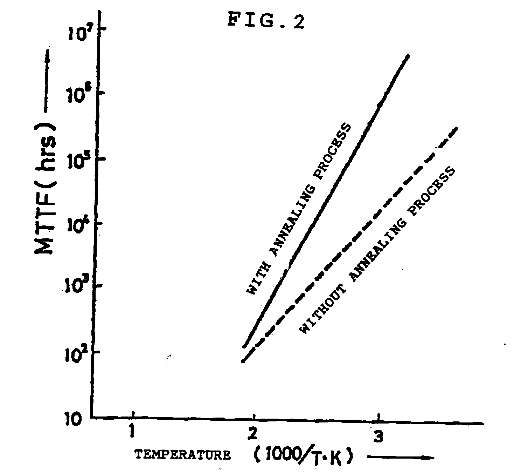

The metal leads 13 of Al-Si-Cu alloy on which Fe is deposited, exhibit significantly greater anti-electromigration characteristics than those without Fe deposition. Further, the substrate 11 metal leads 13 of Al-Si-Cu alloy on which Fe has been deposited is exposed to an atmosphere of N₂ at 450°C for about 30 minutes. As a result, the metal leads 13 with Fe can be annealed, and the anti-electromigration characteristics thereof can be more enhanced as shown in a graph of FIGURE 2. In FIGURE 2, the ordinate represents MTTF (mean time to failure) in hours, which corresponds to an average time elapsed to break the metal leads, and the abscissa represents temperature. The solid line represents the case in which the metal leads are annealed, and the dotted line represents the case in which the metal leads are not annealed.

In this example, a solution containing Fe has been used. However, a solution containing various metals other than Fe can also be used. Such various metals must have an ionization tendency smaller than or equal to Al. In most cases, salt of an appropriate metal selected from such various metals is dissolved in a water solution. As a result, a prescribed solution containing metal ion can be prepared. In such cases, nitrate, sulfate or organic acid salt is used as salt. However, haloid salt is not suitable for such a solution. This is because if the concentration of halogen negative ion in a solution is high, this solution can cause corrosion of the metal leads on the substrate. Even in the case of Fe, if salt chloride is used to prepare a solution having a concentration of about 5 ppm, this solution can also cause corrosion of the metal leads.

It has been confirmed that aluminium can be used to prepare a solution containing metal ion. The solution must have a concentration of several ppm. at most to avoid occurrence of corrosion of the metal leads. In some cases, the pH of such a solution must be predetermined to be dilute acid or alkaline before the specified salt is dissolved in the solution. In such cases, even when the pH of the solution is dilute acid or alkaline, the prescribed metal deposition and the prevention of corrosion can be achieved.

When a metal deposition is performed by using a dilute acid or alkaline solution, a substrate is washed with high-purity water. As a result, the amount of metal deposited on the SiO₂ film on the substrate can be reduced to about half. Thereafter, the substrate is immersed in a dilute acid solution which dissolves the metal. Thus, the metal deposited on the SiO₂ film on the substrate is completely eliminated. The metal deposited on the SiO₂ film can also be eliminated by dry-washing techniques, such as a plasma-applying technique or a light beam-applying technique.

Next, a preferred embodiment according to the present invention will be described. In this embodiment, a solution containing NO₃ ion is employed.

The substrate of FIGURE 1a is immersed in a solution which dissolves nitrate of Al (Al : 1 ppm., NO₃ : 30 ppm.) As a result, passivity films 25 are formed on metal leads 13 of Al-Si-Cu alloy. The existence of passivity films 25 can prevent corrosion of the metal leads 13. Thus, even when the substrate is washed with high-purity water, the widths of metal lead 13 are not reduced. In this embodiment, the Al in the solution is separated therefrom, and selectively deposited on the metal leads 13 of Al-Si-Cu alloy and the SiO₂ film 12. The amount of Al deposited on the SiO₂ film 12 is far smaller than that of the metal leads 13. The amount of Al deposited on the SiO₂ film 12 can be reduced to about half only by washing the substrate 11 with high-purity water. Further, if the substrate 11 is immersed in a very dilute acid solution (e.g., HF), the Al deposited on the SiO₂ film 12 can be eliminated completely. At the same time, Al deposited on the metal leads 13 of Al-Si-Cu alloy is also reduced. However, the amount of Al deposited on the metal leads 13 is sufficiently larger than that of the SiO₂ film 12. Thus, this reduction of Al causes no problems.

As described above, when Al is deposited on the surface of the metal leads of Al-Si-Cu alloy, the metal leads exhibit anti-electromigration characteristics greater than that in the case of without Al-deposition. Metal leads with and without Al-deposition were examined as to their reliability. As a result, it has been confirmed that the metal leads with Al-deposition can withstand for a time about twice longer than those without Al-deposition.

Hereinbefore, the case in which a solution containing both Al and NO₃ is used, has been described. However and as a comparative example not forming part of the present invention, even when a solution containing only NO₃ is used, corrosion of the metal leads can also be prevented. For example, a substrate on which metal leads of Al-Si-Cu alloy have been formed is immersed in a water solution. The water solution contains only NO₃ ion of about 30 ppm (other metals and negative ion [except OH⁻] are not contained). As a result, passivity films are formed on the metal leads, and corrosion thereof can also be prevented.

In some cases, the thus formed passivity films become disadvantages when making contact with other metals in the later process. In such cases, the passivity films can be easily eliminated by using techniques as follows. Specifically, typical eliminating techniques are an etching by use of a solution, a physical technique such as Ar-sputtering, an electric discharge-chemical technique, and an RIE technique. Further, they include a light beam-applying technique, and an electron beam-applying technique.

Next, another embodiment according to the present invention will be described. In the previous embodiments, metal films such as passivity films are formed on metal leads or metal layers provided on a substrate. This is performed by immersing the substrate in a solution.

In this embodiment, ultrasonic waves are applied to the substrate which is being immersed in a solution. In the previous embodiments, metal in a solution is deposited not only on metal portion but also on other portions such as SiO₂ films. The unnecessary metal deposited on the SiO₂ film can be eliminated by use of various techniques. However, in light of the design of semiconductor devices and the productivity in the manufacturing processes thereof, it is, in some cases, required that the metal is deposited only on prescribed portions. In such cases, ultrasonic waves are applied to a substrate which is being immersed in a solution. As a result, the amount of unnecessary metal deposited on portions other than the prescribed portions can be significantly reduced.

Such ultrasonic waves can be easily applied to the substrate by using a conventional ultrasonic washing machine. The ultrasonic waves must have minimum frequencies of 600kHz. The ultrasonic waves of less than 600kHz can probably destroy metal leads on the substrate in the manufacturing processes.

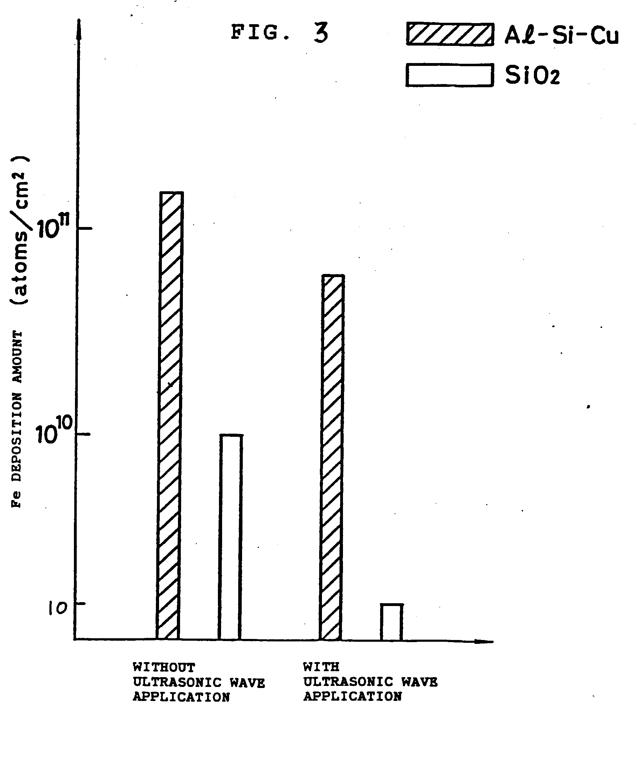

FIGURE 3 shows experimental results of an example not forming part of the present invention in which the amounts of metal deposited on a metal layer and an SiO₂ film were measured in the cases of with and without ultrasonic wave application. Specifically, the substrate of FIGURE 1a was immersed in a solution containing nitrate of Fe (Fe : 5 ppm., NO₃ : 30 ppm.). Thereafter, ultrasonic waves were applied to the metal leads of an Al-Si-Cu alloy and the SiO₂ film on the substrate. As can be seen from FIGURE 3, in the case without ultrasonic wave application, the amount of Fe deposited on the SiO₂ film was about 1/10 times that on the metal leads of an Al-Si-Cu alloy. In the case with ultrasonic wave application, the amount of Fe deposited on the SiO₂ film was about 1/100 times that on the metal leads.

In the previous examples, the Fe deposited on the SiO₂ film can be reduced to about half by washing in with high-purity water. However, in some cases, further reduction of Fe deposited on the SiO₂ film is required for more accurate circuit configuration. In such cases, the substrate is immersed in a dilute HF solution, for example, so as to eliminate the Fe deposited on the SiO₂ film.

In this example, the amount of Fe deposited on the SiO₂ film can be sufficiently reduced by the application of ultrasonic waves. Therefore, the processes of manufacturing semiconductor devices can be significantly simplified.

It is therefore to be understood that within the scope of the appended claims, the invention may be practiced otherwise than as specifically described herein.

## Claims

1. A method of manufacturing semiconductor devices comprising the steps of:
forming aluminium or aluminium alloy leads (13) on the surface of a semiconductor substrate (11), the forming of said leads includes a step of dry etching; and
immersing the semiconductor substrate in a water solution containing aluminium, aluminium is separated from the solution and is deposited on the exposed surfaces of the leads, by immersing the semiconductor substrate in said water solution at least one of F and Cl adhering to the leads due to said dry etching step is eliminated and corrosion of the leads is thereby suppressed.

2. The method of claim 1, wherein said step of immersing the substrate in the solution includes the step of preparing a solution containing an aluminium-salt group other than a halogen salt.

3. The method of claim 2, wherein said aluminium-salt is aluminium nitrate.

4. The method of claim 1, further comprising the step of applying ultrasonic waves to the surfaces of the aluminium or aluminium alloy leads for enhancing the selectivity of the aluminium deposition.

5. The method of claim 4, wherein said step of applying the ultrasonic waves to the surface of the aluminium or aluminium alloy leads includes the step of providing the ultrasonic waves having frequencies of 600 kHz at a lowest.

## Patentansprüche

1. Verfahren zur Herstellung von Halbleiterbausteinen mit den folgenden Schritten:
Ausbildung von Zuleitungen bzw. Anschlußbrücken (13) aus Aluminium oder Aluminiumlegierung auf der Oberfläche eines Halbleitersubstrats (11), wobei die Ausbildung der Zuleitungen einen Trockenätzschritt einschließt; und
Eintauchen des Halbleitersubstrats in eine aluminiumhaltige wäßrige Lösung, wobei Aluminium von der Lösung getrennt und auf den freiliegenden Oberflächen der Zuleitungen abgeschieden wird, wobei durch das Eintauchen des Halbleitersubstrats in die wäßrige Lösung von den infolge des Trockenätzschrittes an den Zuleitungen anhaftenden F und Cl mindestens eines entfernt und dadurch die Korrosion der Zuleitungen unterdrückt wird.

2. Verfahren nach Anspruch 1, wobei der Schritt zum Eintauchen des Substrats in die Lösung den Schritt zur Herstellung einer Lösung aufweist, die eine Aluminiumsalzgruppe enthält, welche kein Halogensalz ist.

3. Verfahren nach Anspruch 2, wobei das Aluminiumsalz Aluminiumnitrat ist.

4. Verfahren nach Anspruch 1, das ferner den Schritt zur Anwendung von Ultraschallwellen auf die Oberflächen der Zuleitungen aus Aluminium oder Aluminiumlegierung aufweist, um die Selektivität der Aluminiumabscheidung zu verstärken.

5. Verfahren nach Anspruch 4, wobei der Schritt zur Anwendung der Ultraschallwellen auf die Oberfläche der Zuleitungen aus Aluminium oder Aluminiumlegierung den Schritt zur Erzeugung von Ultraschallwellen mit Frequenzen von mindestens 600 kHz aufweist.

## Revendications

1. Procédé de fabrication de dispositifs à semi-conducteur comprenant les étapes de :
formation de conducteurs en aluminium ou en alliage d'aluminium (13) sur la surface d'un substrat semi-conducteur (11), la formation desdits conducteurs comprend une étape de gravure à sec ; et
immersion du substrat semi-conducteur dans une solution aqueuse contenant de l'aluminium, l'aluminium est séparé de la solution et déposé sur les surfaces exposées des conducteurs, en immergeant le substrat semi-conducteur dans ladite solution aqueuse au moins d'un de Fe et Cl adhérant aux conducteurs en raison de ladite gravure à sec, l'étape est éliminée et la corrosion des conducteurs est ainsi supprimée.

2. Procédé selon la revendication 1, dans lequel ladite étape d'immersion du substrat dans la solution comprend l'étape de préparation d'une solution contenant un groupe de sel d'aluminium autre qu'un sel d'halogène.

3. Procédé selon la revendication 2, dans lequel ledit sel d'aluminium est un nitrate d'aluminium.

4. Procédé selon la revendication 1, comprenant en outre l'étape d'application d'ondes ultrasonores aux surfaces des conducteurs en aluminium ou en alliage d'aluminium pour augmenter la sélectivité du dépôt d'aluminium.

5. Procédé selon la revendication 4, dans lequel ladite étape d'application des ondes ultrasonores à la surface des conducteurs en aluminium ou en alliage d'aluminium comprend l'étape de fourniture des ondes ultrasonores ayant des fréquences de 600 kHz au moins.
